(19) **Europäisches Patentamt / European Patent Office / Office européen des brevets**

(11) **EP 4 478 055 B1**

(12) **FASCICULE DE BREVET EUROPEEN**

(45) Date de publication et mention
de la délivrance du brevet:
**24.09.2025 Bulletin 2025/39**

(21) Numéro de dépôt: **24181507.5**

(22) Date de dépôt: **11.06.2024**

(51) Classification Internationale des Brevets (IPC):
**G01R 11/24** (2006.01)    **G01R 22/06** (2006.01)

(52) Classification Coopérative des Brevets (CPC):
**G01R 11/24; G01R 22/066; G01R 22/068**

(54) **DETECTION D'UNE INVERSION DE BRANCHEMENT SUR UN COMPTEUR MONOPHASE**

**ERKENNUNG EINER VERZWEIGUNGSUMKEHRUNG AUF EINEM EINPHASIGEN ZÄHLER**

**DETECTING A TURN-OVER SWITCH ON A SINGLE-PHASE METER**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **16.06.2023 FR 2306208**

(43) Date de publication de la demande:
**18.12.2024 Bulletin 2024/51**

(73) Titulaire: **SAGEMCOM ENERGY & TELECOM SAS
92270 Bois-Colombes (FR)**

(72) Inventeurs:
• **ADAM, Sylvestre
92270 Bois-Colombes (FR)**
• **LHUILLIER, Pierre
92270 Bois-Colombes (FR)**

(74) Mandataire: **Cabinet Boettcher
5, rue de Vienne
75008 Paris (FR)**

(56) Documents cités:
**US-A- 5 706 155        US-A1- 2008 024 138
US-A1- 2020 011 910**

## Description

L'invention concerne le domaine des compteurs électriques monophasés.

ARRIERE PLAN DE L'INVENTION

Un compteur électrique monophasé est destiné à mesurer la consommation, par une installation, d'une énergie électrique fournie à l'installation par un réseau de distribution comprenant une phase et un neutre.

Il peut se produire qu'au moment de l'installation du compteur, l'opérateur en charge de l'installation inverse, de manière non intentionnelle, le branchement de la phase et du neutre sur le compteur. Dans ce cas, le neutre du réseau de distribution est connecté à la borne de phase amont du compteur, et la phase du réseau de distribution est connectée à la borne de neutre amont du compteur.

Or, cette inversion de branchement représente un danger pour l'utilisateur (abonné) qui s'attend à ce que le neutre soit peu dangereux, et qui pourrait par conséquent manipuler le neutre de son installation sans savoir qu'il est en réalité connecté à la phase du réseau.

Il s'agit également d'un vecteur potentiel de fraude, car en cas d'inversion du branchement, il devient possible de consommer de l'énergie non mesurée par le compteur, en branchant des équipements entre le neutre et la terre.

Il semble donc particulièrement intéressant d'être capable de détecter automatiquement un défaut d'inversion de branchement, sur un compteur électrique monophasé, entre la phase et le neutre.

Cependant, il n'existe pas aujourd'hui de méthode efficace pour détecter un tel défaut sur les compteurs monophasés.

Dans les compteurs triphasés, la détection d'inversion de branchement est réalisée par la vérification d'un simple critère sur les déséquilibres des tensions. Cependant, un tel critère ne peut pas être appliqué à un compteur monophasé. Un état de la technique pertinent est divulgué dans le document US2020/011910.

OBJET DE L'INVENTION

L'invention a pour objet de détecter efficacement une inversion de branchement entre la phase et le neutre sur un compteur électrique monophasé

RESUME DE L'INVENTION

En vue de la réalisation de ce but, on propose un compteur électrique monophasé, destiné à mesurer une consommation par une installation d'une énergie électrique fournie par un réseau de distribution comprenant une phase et un neutre, le compteur comprenant :

- un conducteur de phase destiné à être relié à la phase ;
- une masse électrique, qui est connectée au conducteur de phase ;
- une cible à potentiel flottant ;
- une unité de traitement agencée pour mesurer une tension cible entre la cible et le conducteur de phase, et pour détecter en fonction de la tension cible un état d'un branchement de la phase et du neutre sur le compteur, l'état du branchement pouvant être un branchement normal ou un branchement inversé.

Lorsque le branchement a été réalisé correctement, la phase du réseau est connectée au conducteur de phase, et la tension cible est relativement élevée. Au contraire, lorsque le branchement a été mal réalisé, c'est le neutre du réseau qui est connecté au conducteur de phase, et la tension cible est relativement basse.

L'intégration dans le compteur de la cible à potentiel flottant permet donc de définir cette tension cible, dont la valeur permet de détecter l'état du branchement de la phase et du neutre sur le compteur. Cette détection, réalisée de façon indirecte par le biais d'un couplage capacitif, est très efficace.

L'invention est par ailleurs très simple et très peu coûteuse à mettre en œuvre, puisqu'elle nécessite simplement d'intégrer la cible dans le compteur.

On propose de plus un compteur électrique monophasé tel que précédemment décrit, dans lequel l'unité de traitement est agencée pour comparer la tension cible avec un seuil prédéterminé, et pour détecter le branchement inversé lorsque la tension cible est inférieure audit seuil prédéterminé.

On propose de plus un compteur électrique monophasé tel que précédemment décrit, dans lequel la cible est une surface conductrice formée sur une carte électrique et non reliée à un plan de masse de ladite carte électrique.

On propose de plus un compteur électrique monophasé tel que précédemment décrit, dans lequel l'unité de traitement comprend des composants de mesure, agencés pour mesurer la tension cible, qui sont montés sur ladite carte électrique.

On propose de plus un compteur électrique monophasé tel que précédemment décrit, l'unité de traitement étant agencée pour détecter une présence d'un individu à proximité du compteur, et pour réaliser la détection de l'état du branchement lorsque l'individu se trouve à proximité du compteur.

On propose de plus un compteur électrique monophasé tel que précédemment décrit, dans lequel le compteur comporte un boîtier comprenant un bouton, l'unité de traitement étant agencée pour détecter la présence de l'individu à proximité du compteur lorsqu'elle détecte un appui sur le bouton.

On propose de plus un compteur électrique monophasé tel que précédemment décrit, dans lequel le compteur comporte un boîtier comprenant une surface de test située sur une surface externe du boîtier, l'unité de traitement étant agencée pour :

- acquérir une information selon laquelle une procédure manuelle de vérification du branchement est démarrée, ladite procédure comprenant l'étape de faire positionner une main ou un doigt de l'individu sur la surface de test ;
- déduire de cette information que l'individu se trouve à proximité du compteur.

On propose de plus un compteur électrique monophasé tel que précédemment décrit, l'unité de traitement étant agencée pour réaliser la détection de l'état du branchement à chaque mise sous tension du compteur.

On propose de plus un procédé de détection, mis en œuvre dans l'unité de traitement d'un compteur électrique monophasé tel que précédemment décrit, et comprenant les étapes de :

- mesurer une tension cible entre la cible et le conducteur de phase ;
- détecter en fonction de la tension cible un état d'un branchement de la phase et du neutre sur le compteur, l'état du branchement pouvant être un branchement normal ou un branchement inversé.

On propose de plus un procédé de détection tel que précédemment décrit, mis en œuvre dans l'unité de traitement d'un compteur électrique monophasé tel que précédemment décrit, comprenant l'étape de détecter une présence d'un individu à proximité du compteur, et de réaliser la détection de l'état du branchement lorsque l'individu se trouve à proximité du compteur.

On propose de plus un procédé de détection tel que précédemment décrit, dans lequel la détection de l'état du branchement comprend les étapes de :

- si la tension cible demeure supérieure à un seuil prédéterminé pendant une première durée prédéterminée, détecter un branchement normal ;
- si la tension cible demeure inférieure à un seuil prédéterminé pendant une deuxième durée prédéterminée, détecter un branchement inversé.

On propose de plus un procédé de détection tel que précédemment décrit, mis en œuvre dans l'unité de traitement d'un compteur électrique monophasé tel que précédemment décrit, comprenant l'étape de réaliser la détection de l'état du branchement à chaque mise sous tension du compteur.

On propose de plus un procédé de détection tel que précédemment décrit, comprenant les étapes de :

- si la tension cible demeure supérieure à un seuil prédéterminé pendant une troisième durée prédéterminée, détecter un branchement normal ;
- si la tension cible demeure inférieure au seuil prédéterminé pendant une quatrième durée prédéterminée, détecter un branchement inversé.

On propose de plus un programme d'ordinateur comprenant des instructions qui conduisent l'unité de traitement du compteur tel que précédemment décrit à exécuter les étapes du procédé de détection tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en œuvre particuliers non limitatifs de l'invention.

BREVE DESCRIPTION DES DESSINS

Il sera fait référence aux dessins annexés parmi lesquels :

[Fig. 1] la figure 1 représente un réseau de distribution et un compteur électrique monophasé, lorsque la phase et le neutre sont correctement branchés sur le compteur ;

[Fig. 2] la figure 2 est une figure similaire à la figure 1, lorsque la phase et le neutre sont inversés ;

[Fig. 3] la figure 3 représente des étapes d'un procédé de détection selon un premier mode de réalisation ;

[Fig. 4] la figure 4 représente des étapes du procédé de détection selon un deuxième mode de réalisation.

## DESCRIPTION DETAILLEE DE L'INVENTION

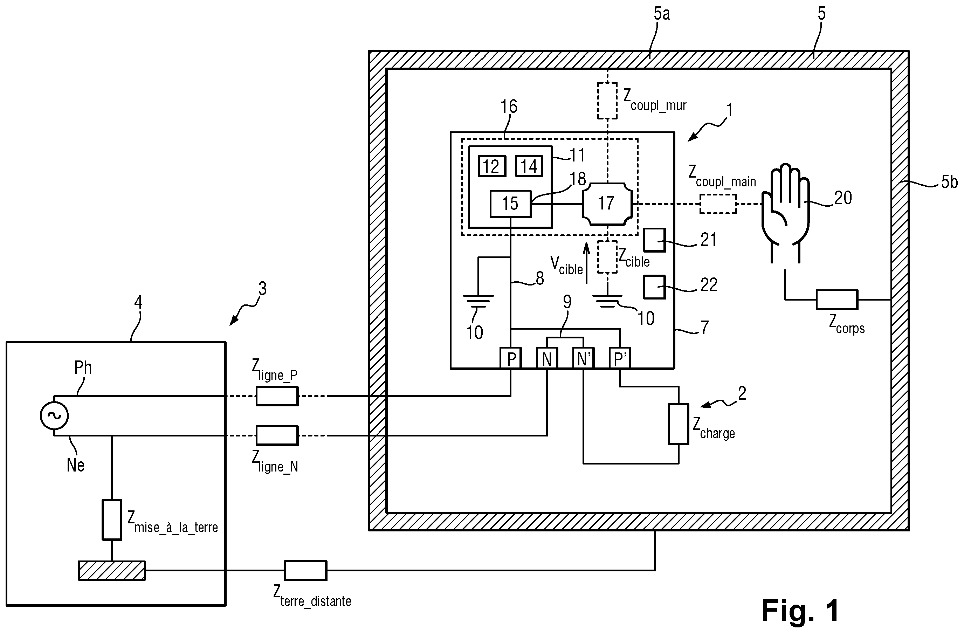

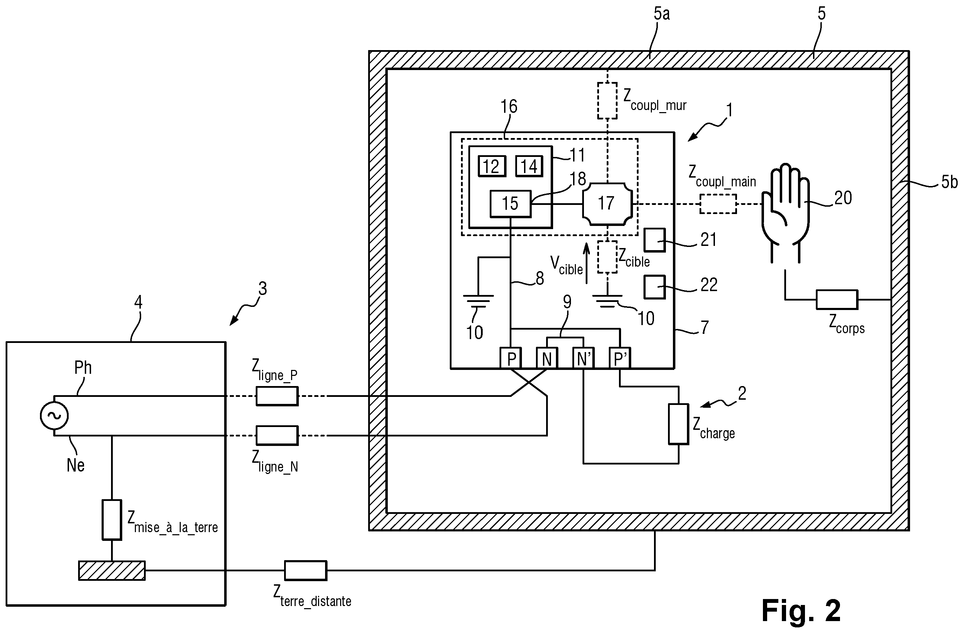

En référence aux figures 1 et 2, le compteur électrique monophasé 1 est destiné à mesurer la consommation d'énergie électrique de l'installation 2 d'un utilisateur (abonné). L'énergie électrique est fournie à l'installation 2 par un réseau de distribution 3.

Le réseau de distribution 3 est un réseau monophasé et comporte une phase Ph et un neutre Ne.

La distribution d'énergie est effectuée indifféremment selon le régime TT ou TN.

Ici, le réseau 3 comprend un poste de distribution 4 auquel sont reliés l'installation 2 et le compteur 1 via la phase Ph et le neutre Ne. Le poste de distribution 4 est un poste de transformation MT/BT.

La tension fournie est ici une tension alternative ayant une tension efficace de 230 V.

L'installation 2 de l'utilisateur et le compteur 1 sont positionnés dans l'habitation de l'utilisateur et donc dans un espace délimité par des murs 5. L'installation 2 est ici symbolisée électriquement par une impédance $Z_{charge}$.

Le compteur 1 comprend un boîtier 7 qui comporte une borne de phase amont P, une borne de neutre amont N, une borne de phase aval P' et une borne de neutre aval N'. Ici, par « amont », on entend du côté du réseau 3 et par « aval », on entend du côté de l'installation 2.

Le compteur 1 comprend un conducteur de phase 8 et un conducteur de neutre 9.

Le conducteur de phase 8 est relié à la borne de phase amont P, et donc à la phase Ph du réseau de distribution 3 en amont du compteur 1. Le conducteur de neutre 9 est relié à la borne de neutre amont N, et donc au neutre Ne du réseau de distribution 3 en amont du compteur 1. La borne de phase aval P' et la borne de neutre aval N' sont reliées à l'installation 2.

Le conducteur de phase 8 est relié à une masse électrique 10 du compteur 1.

Le compteur 1 comprend de plus une unité de traitement 11.

L'unité de traitement 11 comprend au moins un composant de traitement 12, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Specific Integrated Circuit*). Le composant de traitement 12 est ici un microcontrôleur.

L'unité de traitement 11 comprend de plus une ou des mémoires 14, reliées à ou intégrées dans le microcontrôleur 12. Au moins l'une de ces mémoires 14 forme un support d'enregistrement lisible par ordinateur, sur lequel est enregistré au moins un programme d'ordinateur comprenant des instructions qui conduisent le microcontrôleur 12 à exécuter au moins certaines des étapes du procédé de détection qui sera décrit plus bas.

L'unité de traitement 11 comporte de plus des composants de mesure. Les composants de mesure comprennent un convertisseur analogique numérique (CAN) 15 qui produit des mesures numériques d'une tension représentative de la tension présente sur la phase Ph, d'une tension représentative de la tension présente sur le neutre Ne, et d'une tension représentative du courant circulant sur la phase Ph. Ces mesures sont classiquement utilisées par le compteur 1 pour évaluer la consommation électrique de l'installation 2 (métrologie).

Les composants de l'unité de traitement 11 sont ici montés sur une même carte électrique.

La référence de tension du CAN 15 est le plan de masse de la carte électrique 16. Le plan de masse est relié à la masse électrique 10 et donc à la borne de phase amont P.

Le compteur 1 comporte de plus une cible 17 à potentiel flottant, c'est-à-dire un élément conducteur qui n'est connecté à aucun élément ayant un potentiel fixé.

Le CAN 15 comporte une entrée 18 reliée à la cible 17. Le CAN 15 produit donc aussi des mesures de la différence de potentiel entre la cible 17 et la masse électrique 10, et donc entre la cible 17 et la borne de phase amont P du compteur 1.

Le microcontrôleur 12 acquiert et analyse les mesures numériques produites par le CAN 15.

Sur la figure 1, le branchement du compteur 1 a été réalisé correctement par l'opérateur : la phase Ph du réseau 3 est connectée à la borne de phase amont P du compteur 1 (et donc au conducteur de phase 8), et le neutre Ne du réseau 3 est connecté à la borne de neutre amont N du compteur 1 (et donc au conducteur de neutre 9).

Par contre, sur la figure 2, l'opérateur a réalisé une inversion de branchement : la phase Ph du réseau 3 est connectée à la borne de neutre amont N du compteur 1 (et donc au conducteur de neutre 9), et le neutre Ne du réseau 3 est connecté à la borne de phase amont P du compteur 1 (et donc au conducteur de phase 8).

L'invention a pour but de détecter l'état du branchement de la phase Ph et du neutre Ne sur le compteur 1 : l'état du branchement peut être un branchement normal ou un branchement inversé.

On décrit le principe de l'invention.

L'impédance $Z_{cible}$ entre la cible 17 et le plan de masse de la carte 16 est, par construction telle que proposée, élevée. Cette impédance est principalement constituée par la capacité parasite entre la cible 17 et le plan de masse, typiquement de l'ordre du pF, et par l'impédance d'entrée des composants de mesure, typiquement de l'ordre du Mohm.

On voit que la cible 17 est couplée à la terre par un premier couplage capacitif (de manière permanente) et éventuellement, ponctuellement, par un deuxième couplage capacitif.

Le premier couplage est un couplage par l'environnement fixe, c'est à dire ici via l'un des murs 5a.

Le deuxième couplage est un couplage via un individu (typiquement l'opérateur ou l'utilisateur) positionné à proximité du compteur 1, ledit individu étant lui-même couplé à la terre par l'environnement fixe, c'est-à-dire ici via le sol et l'un des murs 5b.

On suppose que l'individu a approché sa main 20 du compteur 1, ou bien même a posé sa main 20 ou un doigt sur le compteur 1.

On a alors :

$$Z_{coupl\_terre} = Z_{coupl\_mur} \; // \; (Z_{coupl\_main} + Z_{corps}),$$

Où :

- $Z_{coupl\_terre}$ est l'impédance de couplage résultante entre la cible 17 et la terre ;
- $Z_{coupl\_mur}$ est l'impédance de couplage entre la cible 17 et la terre via le mur 5a (premier couplage) ;
- $Z_{coupl\_main}$ est l'impédance de couplage entre la cible 17 et la main 20 de l'individu (deuxième couplage) ;
- $Z_{corps}$ est l'impédance de couplage entre le corps de l'individu et la terre via le mur 5b et le sol (deuxième couplage).

Bien sûr, si aucun individu n'est positionné à proximité du compteur 1, la cible 17 est couplée à la terre via le mur 5a uniquement et on a :

$$Z_{coupl\_terre} = Z_{coupl\_mur}$$

L'impédance de terre $Z_{terre\_distante}$, c'est-à-dire l'impédance entre la terre locale du compteur 1 et la terre au niveau de la source de tension réseau (poste de distribution 4) est faible (typiquement < 100 ohms).

Les diversités d'environnement fixe vont rendre le premier couplage très variable (et parfois très faible). Par contre, le deuxième couplage sera toujours conséquent lorsqu'un individu est proche du compteur 1. Cette proximité du corps de l'individu pourra se faire par exemple par sa main : involontairement lors de l'utilisation des boutons 21 du compteur 1, ou volontairement en la posant sur une surface 22 du boîtier 7 du compteur 1 prévue à cet effet lors d'une phase explicite de détection.

Lorsque le câblage est effectué correctement, comme c'est le cas sur la figure 1, la tension cible $V_{cible}$, qui s'établit entre la cible 17 et le plan de masse (et donc le conducteur de phase 8), est donnée par :

$$V_{cible} = V_{réseau} \; x \; Z_{cible} \; / \; (Z_{cible} + Z_{coupl\_terre} + Z_{terre\_distante} +$$
$$Z_{mise\_à\_la\_terre} + (Z_{ligne\_P} \; // \; (Z_{ligne\_N} + Z_{charge})))$$

Or, on a :

$$Z_{terre\_distante} + Z_{mise\_à\_la\_terre} + Z_{ligne\_P} \; << \; Z_{couple\_terre}$$

$$Z_{terre\_distante} + Z_{mise\_à\_la\_terre} + Z_{ligne\_P} \; << \; Z_{cible}$$

$$Z_{ligneP} \; << \; Z_{charge}$$

L'équation ci-dessus peut donc se réécrire de la manière simplifiée suivante :

$$V_{cible} = V_{réseau} \; x \; Z_{cible} \; / \; (Z_{cible} + Z_{coupl\_terre})$$

On constate que, lorsque le câblage est correctement réalisé, une tension significative s'établit alors sur la cible 17, car $Z_{cible}$ est d'un ordre de grandeur supérieur ou similaire à $Z_{couple\_terre}$.

La cible 17 est située à l'intérieur du boîtier 7, puisque le principe de détection se fait sans contact.

La cible 17 est ici une surface conductrice (plage) formée sur la carte électrique 16 et non reliée au plan de masse de ladite carte électrique 16.

La cible 17 est par exemple une surface conductrice carrée de 5mm x 5mm.

Le couplage étant supposé linéaire, la tension cible doit donc être une sinusoïde de même fréquence, et d'amplitude dépendant de la force du couplage cible-terre. Pour que cette amplitude soit relativement importante et donc facilement mesurable, il est préférable que l'impédance du couplage cible-terre (à travers l'environnement fixe ou à travers la main de l'utilisateur) soit d'un ordre de grandeur similaire ou supérieur à l'impédance cible-phase (constituée typiquement par l'impédance d'entrée du CAN 15 et par le couplage parasite entre la cible 17 et le plan de masse du compteur 1 qui est relié à sa borne de phase amont P).

Dans le cas de branchement inversé, illustré en figure 2, la tension cible $V_{cible}$ tend à être nulle. En effet, dans cette configuration, la tension cible $V_{cible}$ s'exprime comme suit :

$$V_{cible} = [V_{réseau} / (1 + (Z_{charge} + Z_{ligne\_P}) / Z_{lign\_N})] \times Z_{cible} / (Z_{cible} + Z_{coupl\_terre} + Z_{terre\_distante} + Z_{mise\_à\_la\_terre} + (Z_{ligne\_P} // (Z_{ligne\_N} + Z_{charge})))$$

Et comme $Z_{charge} >> Z_{ligne\_N}$, la première partie de cette expression tend vers 0.

Ainsi, on constate que la tension cible $V_{cible}$, lorsque le branchement a été correctement réalisé, est nettement supérieure à la tension cible $V_{cible}$ dans le cas d'une inversion de branchement.

L'unité de traitement 11 mesure donc la tension cible $V_{cible}$ entre la cible 17 et le conducteur de phase 8, et détecte en fonction de la tension cible $V_{cible}$ l'état du branchement de la phase Ph et du neutre Ne sur le compteur 1. L'état du branchement peut être un branchement normal ou un branchement inversé.

L'unité de traitement 11 compare la tension cible $V_{cible}$ avec un seuil prédéterminé, et détecte l'inversion de branchement lorsque la tension cible $V_{cible}$ est inférieure audit seuil prédéterminé. Ici, c'est l'amplitude de la valeur efficace de la tension cible qui est comparée avec le seuil prédéterminé.

Le seuil prédéterminé $V_{seuil}$ dépend notamment des dimensions de la cible 17.

Dans l'exemple de dimensionnement de la cible 17 qui a été décrit, le seuil prédéterminé $V_{seuil}$ est par exemple égal à 150 mV.

La tension cible $V_{cible}$ est par exemple une valeur efficace (tension RMS, pour *Root Mean Square*), calculée sur une fenêtre d'intégration de durée égale par exemple à 1s.

La tension cible effectivement présente sur la cible 17 et mesurée via le CAN 15 est une tension alternative de fréquence égale à 50Hz (ou 60Hz).

Un filtrage pourra être mis en œuvre pour filtrer les bruits de plus hautes fréquences provenant de sources perturbatrices susceptibles de biaiser le résultat de mesure (la nature « haute impédance » et éventuellement déportée de la cible la rend potentiellement facilement susceptible aux sources de bruit).

Le filtrage est un filtrage numérique de préférence. Le filtre utilisé est alors par exemple un filtre numérique passe-bande 50Hz d'ordre 2.

Un filtre analogique peut aussi être utilisé.

Le filtre est ici mis en œuvre dans l'unité de traitement 11.

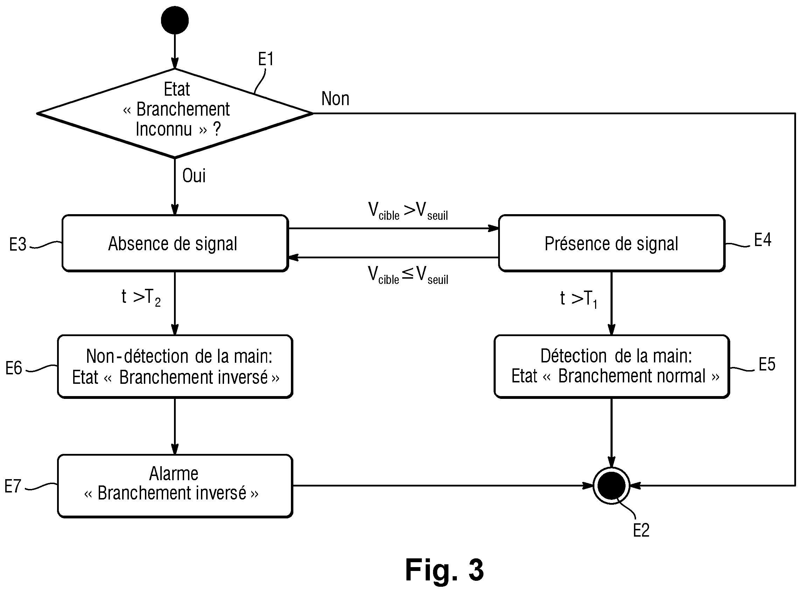

On décrit maintenant, en référence à la figure 3, un premier mode de réalisation du procédé de détection, qui est mis en œuvre dans l'unité de traitement 11.

Le procédé consiste donc à surveiller la tension cible $V_{cible}$, et à effectuer une détection instantanée autour des instants où le couplage avec l'utilisateur est assuré.

Ici, la mesure de la tension cible est réalisée de manière continue, dès la mise sous tension du compteur 1. La détection de l'état du branchement, c'est-à-dire la comparaison avec le seuil prédéterminé et l'analyse du résultat, est réalisée à chaque fois que l'unité de traitement 11 détecte la présence de l'utilisateur (ou d'un autre individu) à proximité du compteur 1. Alternativement, la mesure de la tension cible $V_{cible}$ pourrait débuter uniquement lorsque la présence de l'utilisateur est détectée.

L'unité de traitement 11 peut détecter la présence de l'utilisateur à proximité du compteur 1 lorsqu'elle détecte un appui sur le bouton 21. En effet, lorsqu'un appui sur le bouton 21 du compteur 1 est réalisé, cela signifie nécessairement qu'un individu est positionné à proximité du compteur 1. Le bouton 21 est un bouton quelconque du compteur 1, qui n'est pas a priori dédié à cette fonction (mais qui pourrait l'être).

L'unité de traitement 11 peut aussi utiliser la surface de test 22. Cette surface de test permet de réaliser une procédure manuelle de détection de l'état du branchement. L'utilisateur informe le compteur 1, et l'unité de traitement 11, lorsqu'il souhaite démarrer cette procédure manuelle. Il communique pour cela avec le compteur 1 via une interface quelconque : un bouton sur le compteur 1, en utilisant son *smartphone,* etc. Cette procédure manuelle prévoit que l'utilisateur positionne sa main ou un doigt sur la surface de test 22, qui est positionnée sur la surface externe du boîtier 7 tout en étant située à proximité de la cible 17.

L'unité de traitement 11 acquiert donc une information selon laquelle une procédure manuelle de vérification du branchement est démarrée, ladite procédure comprenant l'étape de faire positionner une main ou un doigt de l'individu sur la surface de test 22. L'unité de traitement 11 déduit de cette information que l'individu se trouve à proximité du compteur 11.

Suite à la détection de la présence de l'individu à proximité du compteur 1, le procédé débute par une étape de démarrage : étape E1.

Si l'état du branchement n'est pas l'état Branchement Inconnu, le procédé passe à l'étape E2, et s'achève.

Si l'état du branchement est l'état Branchement Inconnu, l'unité de traitement 11 analyse la tension cible $V_{cible}$ : étape E3.

Si celle-ci est supérieure au seuil prédéterminé (ici strictement supérieure), le procédé passe à l'étape E4.

A l'étape E4, si la tension cible $V_{cible}$ demeure supérieure au seuil prédéterminé pendant (au moins) une première durée prédéterminée $T_1$, l'unité de traitement 11 détecte la main de l'utilisateur, et donc un branchement normal sur le compteur 1 : étape E5.

La première durée prédéterminée $T_1$ est un seuil temporel (programmable) très court, typiquement égal à quelques secondes.

Le procédé s'achève alors : étape E2.

A l'étape E4, si la tension cible devient inférieure (ici inférieure ou égale) au seuil prédéterminé avant la fin de la première durée prédéterminée $T_1$, le procédé repasse à l'étape E3.

A l'étape E3, si la tension cible demeure inférieure (ici inférieure ou égale) au seuil prédéterminé pendant (au moins) une deuxième durée prédéterminée $T_2$, l'unité de traitement 11 ne détecte pas la main de l'utilisateur, et détecte donc un branchement inversé : étape E6.

La deuxième durée prédéterminée $T_2$ est un seuil temporel (programmable) très court, typiquement égal à quelques secondes.

L'unité de traitement 11 transmet alors une alarme au système central, c'est-à-dire au distributeur d'énergie et/ou au gestionnaire du réseau : étape E7. La remontée de l'alarme se fait typiquement via une communication par courants porteurs en ligne (par exemple selon le protocole CPL-G3), ou bien via une communication radioélectrique (par exemple via le réseau LTE-M ou selon le protocole NB-IoT).

Un message d'alarme, destiné à l'utilisateur, est aussi affiché sur l'écran du compteur 1. L'opérateur en charge de l'installation du compteur 1 peut aussi constater son erreur grâce au message d'alarme et la corriger immédiatement.

Le procédé se termine alors : étape E2.

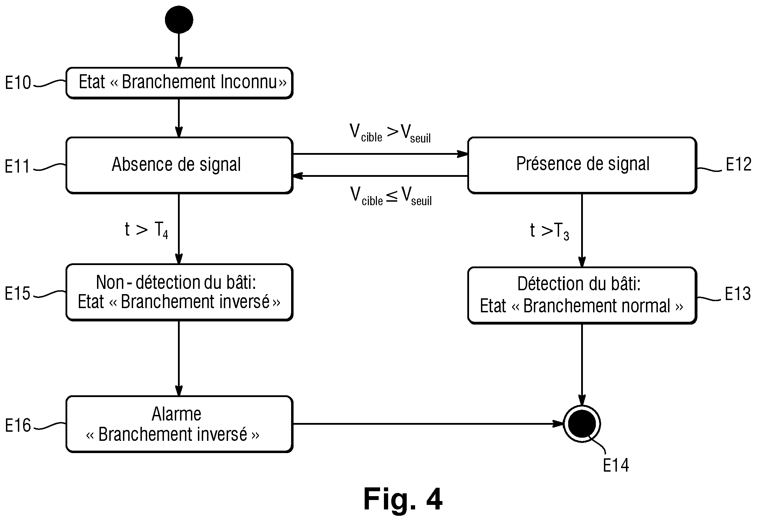

On décrit maintenant, en référence à la figure 4, un deuxième mode de réalisation du procédé de détection, qui est mis en œuvre dans l'unité de traitement 11.

Ce mode de réalisation consiste à surveiller la tension cible $V_{cible}$, et à chercher une longue période consécutive d'absence de signal pour la détection du bâti.

Ici, la mesure de la tension cible $V_{cible}$ et la détection de l'état du branchement, c'est-à-dire la comparaison avec le seuil prédéterminé, sont réalisées de manière continue, dès la mise sous tension du compteur 1.

Etant donné que le branchement du compteur 1 se fait nécessairement hors tension, le procédé de détection est déclenché à chaque mise sous tension pour vérifier que le sens de câblage est correct lors de l'installation initiale, ou qu'il n'a pas été modifié lors de la dernière mise hors tension. L'état initial de l'état du branchement est donc l'état Inconnu au démarrage du procédé : étape E10.

L'unité de traitement 11 analyse la tension cible $V_{cible}$ : étape E11.

Si celle-ci est supérieure au seuil prédéterminé (ici strictement supérieure), le procédé passe à l'étape E12.

A l'étape E12, si la tension cible demeure supérieure au seuil prédéterminé pendant (au moins) une troisième durée prédéterminée $T_3$, l'unité de traitement 11 détecte le bâti, et donc un branchement normal sur le compteur 1 : étape E13.

La troisième durée prédéterminée $T_3$ est un seuil temporel (programmable) assez court pour éviter les faux positifs, typiquement égal à dix secondes.

Le procédé s'achève alors : étape E14.

A l'étape E12, si la tension cible devient inférieure (ici inférieure ou égale) au seuil prédéterminé avant la fin de la troisième durée prédéterminée $T_3$, le procédé repasse à l'étape E11.

A l'étape E11, si la tension cible demeure inférieure (ici inférieure ou égale) au seuil prédéterminé pendant (au moins) une quatrième durée prédéterminée $T_4$, l'unité de traitement 11 ne détecte pas le bâti, et détecte donc un branchement inversé : étape E15.

La quatrième durée prédéterminée $T_4$ est un seuil temporel (programmable) assez long pour éviter les faux positifs, typiquement égal à une heure.

L'unité de traitement 11 transmet alors une alarme au système central, c'est-à-dire au distributeur d'énergie et/ou au gestionnaire du réseau : étape E16. La remontée de l'alarme se fait typiquement via une communication par courants porteurs en ligne (par exemple selon le protocole CPL-G3), ou bien via une communication radioélectrique (par exemple via le réseau LTE-M ou selon le protocole NB-IoT).

Un message d'alarme, destiné à l'utilisateur, est aussi affiché sur l'écran du compteur 1. L'opérateur en charge de l'installation du compteur 1 peut aussi constater son erreur grâce au message d'alarme et la corriger immédiatement.

Le procédé se termine alors : étape E14.

Quel que soit le mode de réalisation du procédé de détection, il est possible de prévoir que le procédé soit débrayable : le distributeur d'énergie et/ou le gestionnaire du réseau et/ou l'utilisateur peuvent décider de désactiver cette fonction.

Les deux modes de réalisation peuvent bien sûr être combinés. Ainsi, la détection selon le deuxième mode de réalisation sera mise en œuvre à chaque mise sous tension du compteur 1, et la détection selon le premier mode de réalisation sera mise en œuvre à chaque fois que l'unité de traitement 11 détecte la présence de l'individu à proximité du compteur 1.

Bien entendu, l'invention n'est pas limitée aux modes de réalisation décrits mais englobe toute variante entrant dans le champ de l'invention tel que défini par les revendications.

La surface cible pourrait être de forme et de dimensions différentes de celles citées ici. Elle pourrait être positionnée différemment dans le compteur (elle n'est pas positionnée nécessairement sur une carte électrique).

La cible pourrait notamment être déportée au-dessus, en dessous ou à côté de la carte électrique.

La cible est par exemple située à 1 cm du plan de masse de la carte électrique en étant surélevée.

La cible est alors par exemple positionnée sur une pièce mécanique (support) prévue à cet effet afin d'en assurer une localisation bien maitrisée, et est reliée à la carte électrique (pour la mesure de tension par le CAN) par un fil conducteur, dont la taille et le positionnement sont assurés avec soin pour que le couplage qu'elle apporte avec le plan de masse de la carte reste négligeable, ou tout du moins pris en compte dans le dimensionnement global.

On note que lorsque la cible est directement intégrée sur la carte électrique, on a une distance par rapport au plan de masse plus typiquement de l'ordre de 1mm. Si ce dernier cas apporte un couplage trop important avec le plan de masse de la carte, il peut être considéré un « détourage » du plan de masse des couches de cuivre du circuit imprimé qui sont en vis-à-vis de la cible, et avoir par exemple un couplage plutôt de type coplanaire.

Les solutions géométriques sont en pratique multiples, selon la surface de la cible, son positionnement par rapport à la masse de la carte électrique (qu'elle soit déportée ou non) et par rapport aux surfaces externes du boitier.

Pour améliorer encore le couplage cible-terre, il est possible d'utiliser à l'intérieur du boîtier et à proximité de la cible une surépaisseur d'un matériau plein (par exemple et préférentiellement plastique) apportant une permittivité notablement plus importante que l'air, ce qui permet d'atteindre des distances plus importantes et/ou un couplage capacitif plus important qu'avec un même volume empli d'air.

La détection de la présence d'un individu à proximité du compteur pourrait être réalisée de manière différente, et notamment grâce à tout type de capteur de proximité.

L'architecture de la carte électrique et les composants utilisés pourraient être différents. On peut par exemple intégrer aux composants d'acquisition de la tension cible un étage d'amplification et de protection, comprenant par exemple un amplificateur opérationnel. Les composants de l'unité de traitement ne sont pas nécessairement tous montés sur une même carte électrique.

**Revendications**

**1.** Compteur électrique monophasé (1), destiné à mesurer une consommation par une installation (2) d'une énergie électrique fournie par un réseau de distribution (3) comprenant une phase (Ph) et un neutre (Ne), le compteur comprenant :

- un conducteur de phase (8) destiné à être relié à la phase ;
- une masse électrique (10), qui est connectée au conducteur de phase ;

**caractérisé en ce que** le compteur comprend en outre:

- une cible (17) à potentiel flottant ;
- une unité de traitement (11) agencée pour mesurer une tension cible ($V_{cible}$) entre la cible et le conducteur de phase, et pour détecter en fonction de la tension cible un état d'un branchement de la phase et du neutre sur le compteur (1), l'état du branchement pouvant être un branchement normal ou un branchement inversé.

**2.** Compteur électrique monophasé selon la revendication 1, dans lequel l'unité de traitement (11) est agencée pour comparer la tension cible avec un seuil prédéterminé, et pour détecter le branchement inversé lorsque la tension cible est inférieure audit seuil prédéterminé.

3. Compteur électrique monophasé selon l'une des revendications précédentes, dans lequel la cible (17) est une surface conductrice formée sur une carte électrique (16) et non reliée à un plan de masse de ladite carte électrique.

4. Compteur électrique monophasé selon la revendication 3, dans lequel l'unité de traitement (11) comprend des composants de mesure (15), agencés pour mesurer la tension cible, qui sont montés sur ladite carte électrique.

5. Compteur électrique monophasé selon l'une des revendications précédentes, l'unité de traitement (11) étant agencée pour détecter une présence d'un individu à proximité du compteur, et pour réaliser la détection de l'état du branchement lorsque l'individu se trouve à proximité du compteur (1).

6. Compteur électrique monophasé selon la revendication 5, dans lequel le compteur (1) comporte un boîtier (7) comprenant un bouton (21), l'unité de traitement (11) étant agencée pour détecter la présence de l'individu à proximité du compteur lorsqu'elle détecte un appui sur le bouton.

7. Compteur électrique monophasé selon l'une des revendications 5 ou 6, dans lequel le compteur comporte un boîtier (7) comprenant une surface de test (22) située sur une surface externe du boîtier (7), l'unité de traitement étant agencée pour :

   - acquérir une information selon laquelle une procédure manuelle de vérification du branchement est démarrée, ladite procédure comprenant l'étape de faire positionner une main ou un doigt de l'individu sur la surface de test (22) ;
   - déduire de cette information que l'individu se trouve à proximité du compteur (1).

8. Compteur électrique monophasé selon l'une des revendications précédentes, l'unité de traitement (11) étant agencée pour réaliser la détection de l'état du branchement à chaque mise sous tension du compteur.

9. Procédé de détection, mis en œuvre dans l'unité de traitement (11) d'un compteur électrique monophasé (1) selon l'une des revendications précédentes, et comprenant les étapes de :

   - mesurer une tension cible ($V_{cible}$) entre la cible (17) et le conducteur de phase (8) ;
   - détecter en fonction de la tension cible un état d'un branchement de la phase et du neutre sur le compteur (1), l'état du branchement pouvant être un branchement normal ou un branchement inversé.

10. Procédé de détection selon la revendication 9, mis en œuvre dans l'unité de traitement (11) d'un compteur électrique monophasé (1) selon la revendication 5, comprenant l'étape de détecter une présence d'un individu à proximité du compteur, et de réaliser la détection de l'état du branchement lorsque l'individu se trouve à proximité du compteur.

11. Procédé de détection selon la revendication 10, dans lequel la détection de l'état du branchement comprend les étapes de :

   - si la tension cible demeure supérieure à un seuil prédéterminé pendant une première durée prédéterminée ($T_1$), détecter un branchement normal ;
   - si la tension cible demeure inférieure au seuil prédéterminé pendant une deuxième durée prédéterminée ($T_2$), détecter un branchement inversé.

12. Procédé de détection selon l'une des revendications 9 à 11, mis en œuvre dans l'unité de traitement (11) d'un compteur électrique monophasé selon la revendication 8, comprenant l'étape de réaliser la détection de l'état du branchement à chaque mise sous tension du compteur.

13. Procédé de détection selon la revendication 12, comprenant les étapes de :

   - si la tension cible demeure supérieure à un seuil prédéterminé pendant une troisième durée prédéterminée ($T_3$), détecter un branchement normal ;
   - si la tension cible demeure inférieure au seuil prédéterminé pendant une quatrième durée prédéterminée ($T_4$), détecter un branchement inversé.

**14.** Programme d'ordinateur comprenant des instructions qui conduisent l'unité de traitement (11) du compteur (1) selon la revendication 1 à exécuter les étapes du procédé de détection selon la revendication 9.

**15.** Support d'enregistrement lisible par ordinateur, sur lequel est enregistré le programme d'ordinateur selon la revendication 14.

**Patentansprüche**

**1.** Einphasiger Stromzähler (1) zur Messung einer von einer Anlage (2) verbrauchten elektrischen Energie, die von einem eine Phase (Ph) und einen Neutralleiter (Ne) umfassenden Verteilungsnetz (3) geliefert wird, wobei der Zähler umfasst:

- einen Phasenleiter (8), der dazu bestimmt ist, mit der Phase verbunden zu werden;
- eine elektrische Masse (10), die an den Phasenleiter angeschlossen ist;

**dadurch gekennzeichnet, dass** der Zähler ferner umfasst:

- ein Ziel (17) mit schwebendem Potential;
- eine Verarbeitungseinheit (11), die dafür ausgelegt ist, eine Zielspannung ($V_{cible}$) zwischen dem Ziel und dem Phasenleiter zu messen und in Abhängigkeit zu der Zielspannung einen Zustand eines Anschlusses der Phase und des Neutralleiters an dem Zähler (1) zu erkennen, wobei es sich bei dem Anschlusszustand um einen normalen Anschluss oder um einen umgekehrten Anschluss handeln kann.

**2.** Einphasiger Stromzähler nach Anspruch 1, wobei die Verarbeitungseinheit (11) dafür ausgelegt ist, die Zielspannung mit einem vorbestimmten Schwellenwert zu vergleichen und den umgekehrten Anschluss zu erkennen, wenn die Zielspannung unter dem vorbestimmten Schwellenwert liegt.

**3.** Einphasiger Stromzähler nach einem der vorhergehenden Ansprüche, wobei es sich bei dem Ziel (17) um eine auf einer elektrischen Karte (16) ausgebildete leitfähige Fläche handelt, die nicht mit einer Masseebene der elektrischen Karte verbunden ist.

**4.** Einphasiger Stromzähler nach Anspruch 3, wobei die Verarbeitungseinheit (11) Messkomponenten (15) zur Messung der Zielspannung umfasst, die auf der elektrischen Karte montiert sind.

**5.** Einphasiger Stromzähler nach einem der vorhergehenden Ansprüche, wobei die Verarbeitungseinheit (11) dafür ausgelegt ist, die Anwesenheit einer Person in der Nähe des Zählers zu erkennen und die Erkennung des Anschlusszustands durchzuführen, wenn sich die Person in der Nähe des Zählers (1) aufhält.

**6.** Einphasiger Stromzähler nach Anspruch 5, wobei der Zähler (1) ein Gehäuse (7) mit einem Druckknopf (21) enthält, wobei die Verarbeitungseinheit (11) dafür ausgelegt ist, die Anwesenheit der Person in der Nähe des Zählers zu erkennen, wenn ein Knopfdruck erkannt wird.

**7.** Einphasiger Stromzähler nach einem der Ansprüche 5 oder 6, wobei der Zähler ein Gehäuse (7) mit einer Testfläche (22) enthält, die auf einer Außenfläche des Gehäuses (7) angeordnet ist, wobei die Verarbeitungseinheit dafür ausgelegt ist:

- eine Information zu erfassen, dass ein manuelles Prüfverfahren zur Überprüfung des Anschlusses gestartet worden ist, wobei das Verfahren den Schritt umfasst, dass eine Hand oder ein Finger der Person auf die Testfläche (22) gelegt werden muss;
- aus dieser Information abzuleiten, dass sich die Person in der Nähe des Zählers (1) aufhält.

**8.** Einphasiger Stromzähler nach einem der vorhergehenden Ansprüche, wobei die Verarbeitungseinheit (11) dafür ausgelegt ist, die Erkennung des Anschlusszustands bei jedem Einschalten des Zählers durchzuführen.

**9.** Detektionsverfahren, welches in der Verarbeitungseinheit (11) eines einphasigen Stromzählers (1) nach einem der vorhergehenden Ansprüche ausgeführt wird und die Schritte umfasst, dass:

## EP 4 478 055 B1

- eine Zielspannung ($V_{cible}$) zwischen dem Ziel (17) und dem Phasenleiter (8) gemessen wird;
- in Abhängigkeit zu der Zielspannung ein Zustand eines Anschlusses der Phase und des Neutralleiters an dem Zähler (1) erkannt wird, wobei es sich bei dem Anschlusszustand um einen normalen Anschluss oder um einen umgekehrten Anschluss handeln kann.

10. Detektionsverfahren nach Anspruch 9, welches in der Verarbeitungseinheit (11) eines einphasiger Stromzählers (1) nach Anspruch 5 ausgeführt wird, umfassend den Schritt, dass eine Anwesenheit einer Person in der Nähe des Zählers erkannt wird und die Erkennung des Anschlusszustands durchgeführt wird, wenn sich die Person in der Nähe des Zählers aufhält.

11. Detektionsverfahren nach Anspruch 10, wobei die Erkennung des Anschlusszustands die Schritte umfasst, dass:

- wenn die Zielspannung während einer ersten vorbestimmten Zeitdauer ($T_1$) über einem vorbestimmten Schwellenwert bleibt, ein normaler Anschluss erkannt wird;
- wenn die Zielspannung während einer zweiten vorbestimmten Zeitdauer ($T_2$) unter dem vorbestimmten Schwellenwert bleibt, ein umgekehrter Anschluss erkannt wird;

12. Detektionsverfahren nach einem der Ansprüche 9 bis 11, welches in der Verarbeitungseinheit (11) eines einphasigen Stromzählers nach Anspruch 8 ausgeführt wird, umfassend den Schritt, dass die Erkennung des Anschlusszustands bei jedem Einschalten des Zählers durchgeführt wird.

13. Detektionsverfahren nach Anspruch 12, welches die Schritte umfasst, dass:

- wenn die Zielspannung während einer dritten vorbestimmten Zeitdauer ($T_3$) über einem vorbestimmten Schwellenwert bleibt, ein normaler Anschluss erkannt wird;
- wenn die Zielspannung während einer vierten vorbestimmten Zeitdauer ($T_4$) unter dem vorbestimmten Schwellenwert bleibt, ein umgekehrter Anschluss erkannt wird.

14. Computerprogramm, das Befehle umfasst, welche die Verarbeitungseinheit (11) des Zählers (1) nach Anspruch 1 dazu veranlassen, die Schritte des Detektionsverfahrens nach Anspruch 9 auszuführen.

15. Computerlesbares Speichermedium, auf welchem das Computerprogramm nach Anspruch 14 abgespeichert ist.

**Claims**

1. Single-phase electric meter (1), intended to measure a consumption by an installation (2) of an electrical energy supplied by a distribution network (3) comprising a phase (Ph) and a neutral (Ne), the meter comprising:

- a phase conductor (8) intended to be connected to the phase;
- an electrical ground (10), which is connected to the phase conductor;

**characterized in that** the meter further comprises :

- a floating potential target (17);
- a processing unit (11) arranged to measure a target voltage ($V_{target}$) between the target and the phase conductor, and to detect, according to the target voltage, a state of a connection of the phase and of the neutral on the meter (1), the state of the connection being able to be a normal connection or a crossed connection.

2. Single-phase electric meter according to claim 1, wherein the processing unit (11) is arranged to compare the target voltage with a predetermined threshold, and to detect the crossed connection when the target voltage is less than said predetermined threshold.

3. Single-phase electric meter according to one of the preceding claims, wherein the target (17) is a conductive surface formed on an electrical board (16) and not connected to a ground plane of said electrical board.

4. Single-phase electric meter according to claim 3, wherein the processing unit (11) comprises measuring components (15), arranged to measure the target voltage, which are mounted on said electrical board.

5. Single-phase electric meter according to one of the preceding claims, the processing unit (11) being arranged to detect a presence of an individual in the proximity of the meter, and to perform the detection of the state of the connection when the individual is located in the proximity of the meter (1).

6. Single-phase electric meter according to claim 5, wherein the meter (1) comprises a casing (7) comprising a button (21), the processing unit (11) being arranged to detect the presence of the individual in the proximity of the meter when it detects a press on the button.

7. Single-phase electric meter according to one of claims 5 or 6, wherein the meter comprises a casing (7) comprising a test surface (22) located on an external surface of the casing (7), the processing unit being arranged to:

- acquire information, according to which a procedure for manually checking the connection is started, said procedure comprising the step of positioning a hand or a finger of the individual on the test surface (22);
- deduce from this information that the individual is located in the proximity of the meter (1).

8. Single-phase electric meter according to one of the preceding claims, the processing unit (11) being arranged to perform the detection of the state of the connection each time the meter is switched on.

9. Detection method, implemented in the processing unit (11) of a single-phase electric meter (1) according to one of the preceding claims, and comprising the steps of:

- measuring a target voltage ($V_{target}$) between the target (17) and the phase conductor (8);
- detecting, according to the target voltage, a state of a connection of the phase and of the neutral on the meter (1), the state of the connection being able to be a normal connection or a crossed connection.

10. Detection method according to claim 9, implemented in the processing unit (11) of a single-phase electric meter (1) according to claim 5, comprising the step of detecting a presence of an individual in the proximity of the meter, and of performing the detection of the state of the connection when the individual is located in the proximity of the meter.

11. Detection method according to claim 10, wherein the detection of the state of the connection comprises the steps of:

- if the target voltage remains greater than a predetermined threshold for a first predetermined duration ($T_1$), detecting a normal connection;
- if the target voltage remains less than the predetermined threshold for a second predetermined duration ($T_2$), detecting a crossed connection.

12. Detection method according to one of claims 9 to 11, implemented in the processing unit (11) of a single-phase electric meter according to claim 8, comprising the step of performing the detection of the state of the connection each time the meter is switched on.

13. Detection method according to claim 12, comprising the steps of:

- if the target voltage remains greater than a predetermined threshold for a third predetermined duration ($T_3$), detecting a normal connection;
- if the target voltage remains less than the predetermined threshold for a fourth predetermined duration ($T_4$), detecting a crossed connection.

14. Computer program comprising instructions which leads the processing unit (11) of the meter (1) according to claim 1 to execute the steps of the detection method according to claim 9.

15. Computer-readable recording medium, on which the computer program according to claim 14 is recorded.

Fig. 1

EP 4 478 055 B1

$Z_{coupl\_mur}$

$Z_{coupl\_main}$

$Z_{cible}$

$V_{cible}$

$Z_{corps}$

$Z_{charge}$

$Z_{ligne\_P}$

$Z_{ligne\_N}$

$Z_{mise\_à\_la\_terre}$

$Z_{terre\_distante}$

**Fig. 2**

EP 4 478 055 B1

Fig. 3

Fig. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2020011910 A